# EUROPEAN PATENT SPECIFICATION

(11) **EP 4 218 062 B1**
(45) Date of publication and mention of the grant of the patent: **23.04.2025**
(21) Application number: 21794958.5
(22) Date of filing: 24.09.2021
(51) Int. Cl.: H01L 31/048, C03C 27/06, C03C 27/10

(54) **FIRE-RESISTANT PHOTOVOLTAIC GLASS PANE AND PANEL FOR ARCHITECTURAL ELEMENTS**
FEUERFESTE FOTOVOLTAISCHE GLASSCHEIBE UND PLATTE FÜR ARCHITEKTONISCHE ELEMENTE
PANNEAU EN VERRE PHOTOVOLTAÏQUE RÉSISTANT AU FEU ET PANNEAU POUR ÉLÉMENTS ARCHITECTURAUX

(30) Priority: 28.09.2020 IT 202000022768
(43) Date of publication of application: 02.08.2023
(73) Proprietor: Pan Elettrica Panzeri S.r.l., 22040 Monguzzo (CO) (IT)
(72) Inventor: RIVA, Matteo, 22040 Monguzzo (CO) (IT)
(74) Representative: Raimondi, Margherita
(86) International application number: PCT/IB2021/058728
(87) International publication number: WO 2022/064440

(56) References cited:
- US-A1- 2012 132 269

## Description

The present invention relates to a photovoltaic laminated glass pane and a structural photovoltaic panel with fire-resistant properties, and architectural elements which use such a glass pane or panel.

It is known in the technical sector of photovoltaic glass panes that these are generally formed by a sandwich structure comprising several layers superimposed in a thickness direction, said layers comprising a photovoltaic layer.

The photovoltaic layer generally has an active layer, for example comprising a plurality of photovoltaic cells, which is enclosed between two layers of transparent thermoplastic resin (usually polyvinyl butyral, PVB). The active layer has, combined therewith, on-board electronics and connection means such as cables and connectors for electrical connection and control of the photovoltaic active layer. Document US 2012 132269 A1 discloses a thin-film solar cell formed as a glazing pane according to the preamble of Claim 1, having first and second planar glass substrates with a softening point over 725°C in order to better withstand the high-temperature photovoltaic coating process for deposition of a photovoltaic coating interposed between the two planar glass substrates.

It is also known that photovoltaic glass panes or photovoltaic sandwich structures may be included in structural panels for buildings, in which case the photovoltaic structural panel overall must satisfy the mechanical requisites for making the panel classifiable as a structural safety panel, prescribed in the relevant standards, including in particular standard UNI 7679.2007, and for which structural calculation models used by design engineers in the sector are known.

The structural photovoltaic panels therefore have the dual characteristic that they produce electric energy by means of the photovoltaic layer and act as an architectural building element.

In general there exist a plurality of standards relating to glass panes and glass panels, in particular relating to the material itself, to the modes of use and its performance features, including:
- NTC 2008
- UNI EN 572-2:2004: Float glass
- UNI 6534-74:1994: Design, materials and laying
- UNI EN 572-1:2004: Definitions and general physical and mechanical properties
- UNI 7143-72:1972: Thickness of flat glass for glazing in relation to their dimensions, wind loads and snow loads.
- UNI 7697:2007 (revision of 2002 edition): Safety criteria for glazing applications
- UNI EN 1288-1:2001: Determination of the bending strength of glass
- UNI EN 1288-1:2001 and UNI EN 1288-3:2001: Determination of the bending strength of glass
- UNI EN 1863-1:2002 and UNI EN 1863-2:2005: Heat hardened glass
- UNI EN 12150-1:2001 and UNI EN 12150-2:2005: Heat hardened safety glass
- UNI EN 12337-1:2001 and UNI EN 12337-1:2005: Chemically hardened glass.
- UNI EN ISO 12543-1:2000 - 2:2000 - 3:2000 - UNI EN ISO 12543 (replaces UNI 7172): Laminated glass and laminated safety glass
- UNI EN 12600: 2004: Glass for building - Pendulum test - Impact test method and classification for flat glass
- Italian Decree Law No. 115 dated 1995 (implemented by European Directive 1992/59/CE). Makes reference to the standard UNI 7679. Relates to the general safety of glazed products.
- Italian Decree Law No. 172 dated 2004 (implemented by European Directive 2001/95/CE). Makes reference to the standard UNI 7679. Relates to the general safety of glazed products.
- European Standard prEN 13474-3 (CEN/TC129/WG8): Design of structural glass components
- Standard CNR-DT 210/2013: Instructions for the design, execution and verification of buildings with structural glass components

Furthermore the certifications CEI EN 61215 and CEI EN 61730 are applicable for PVB laminated safety glass.

According to the present state of the art, in the sector in question, there does not exist a commercially available photovoltaic glass pane which has adequate fire-resistance properties for applications where fire-prevention is required.

Likewise, there does not exist in the technical sector a photovoltaic structural panel which has adequate fire-resistance properties for use in applications where fire-prevention is required. In particular there is no known photovoltaic structural panel which may be classified as E30 or E45 in accordance with the criteria defined by the standard UNI EN1363-1 (2012) relating to passive fire-resistant glass.

The technical problem which is posed therefore is that of providing a photovoltaic glass and/or structural photovoltaic panel with improved fire-resistance properties.

A particular object of the present invention is to provide a photovoltaic glass and/or structural photovoltaic panel, with improved structural strength and fire-resistance properties, in particular in relation to mechanical shocks during a fire.

In connection with this problem, it is also required that the glass or panel should have small dimensions (in particular as regards its thickness), be easy and inexpensive to produce and be able to be easily installed using normal standardized means.

These results are obtained according to the present invention by a laminated photovoltaic glass plane according to the characteristic features of Claim 1 and by a fire-resistant photovoltaic panel according to Claim 16.

The present invention relates furthermore to a process according to claim for producing the photovoltaic structural glass pane and a structural element provided with the photovoltaic panel.

Further details may be obtained from the following description of non-limiting examples of embodiment of the subject of the present invention, provided with reference to the accompanying drawings, in which:
Figure 1: is a schematic view cross-sectioned along a direction of thickness of the structure of a photovoltaic laminated glass pane according to the present invention;
Figure 2: is a plan view from the sun side of an example of embodiment of a photovoltaic layer of the glass according to Figure 1;
Figure 3: is a schematic view cross-sectioned along a direction of thickness of a first example of embodiment of a photovoltaic panel according to the present invention in the form of double-glazed unit retained by glass-fastening means.
Figure 4: is a schematic, exploded, cross-sectional view of a continuous façade element according to the invention, which includes the panel shown in Figure 3;
Figure 5: is a schematic cross-sectional view of the continuous façade element of Fig. 4, assembled and fixed to a wall.

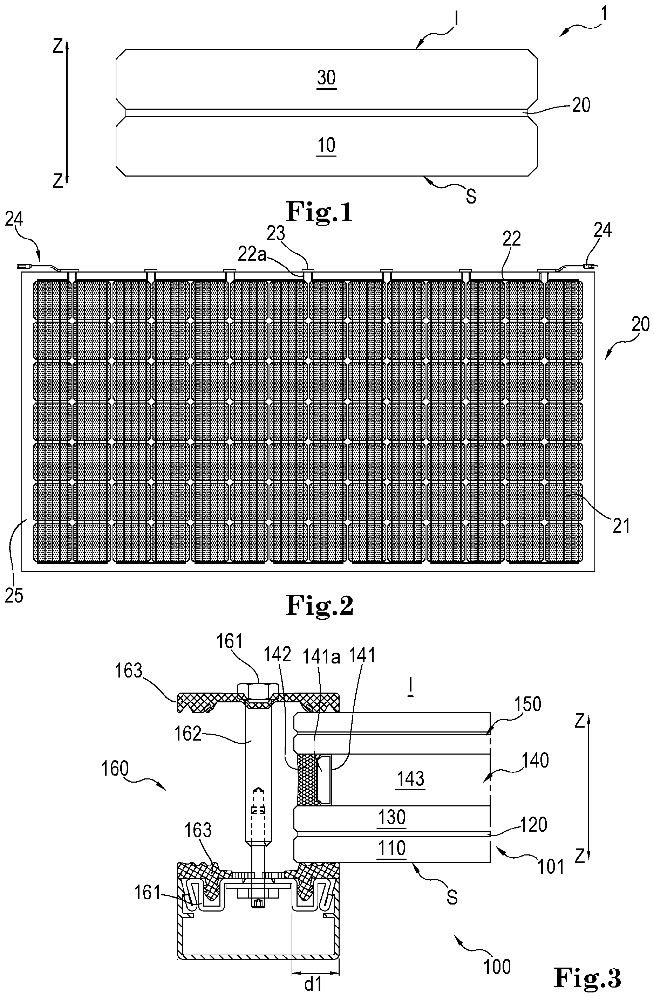

With reference to Figure 1, an example of embodiment a photovoltaic laminated glass pane 1 according to the invention extends in a thickness direction Z-Z between a front side or sun side "S" and a rear side or inner side "I" and comprises a front glass sheet 10, the front surface of which forms the sun side S which during use is exposed to the sun, a rear glass sheet 30 and at least one photovoltaic layer 20 arranged between the front glass sheet 10 and the rear glass sheet 30.

With reference to Figure 2, the photovoltaic layer 20 has an active layer which is designed to be irradiated by solar energy and produce electric energy and which is enclosed between two layers 25 of transparent thermoplastic resin, preferably consisting of PVB. In particular, the active layer 20 comprises a plurality of photovoltaic cells 21. The photovoltaic cells 21 may be made from crystalline silicon, with electrical interconnection means 22, for example in the form of ribbons, in particular made of copper. It is understood that the photovoltaic layer 20 may also comprise a different number of layers of thermoplastic resin and/or a different active layer.

The interconnection means 22 may connect together a plurality of cells 21 and form output terminals 22a of the active layer for connection to/from the outside.

As shown, in preferred embodiments, the ribbons 22 may be arranged so as to form a plurality of terminals 22a arranged along the outer perimetral edge of the active layer, so as to provide connection terminals of the cells 21 with the outside for the active layer, emerging from the sandwich arrangement of the two PVB resin layers which encloses the active layer.

The active layer 20 has, combined therewith, on-board electronics 23 and connection means such as cables and connectors 24 for electrical connection and control of the photovoltaic active layer.

The on-board electronics may comprise, for example, diodes housed inside containers 23, for example made of ABS, and embedded in thermo-conductive, dielectric, adhesive silicone. Electronics 23 and cables 24 may be for example directly welded to the output ribbons 22a of the glass, the welds being for example insulated with silicone.

Advantageously, the active layer with connection terminals 22a and/or on-board connection electronics arranged along the perimetral edges allows the whole of the electrical/electronic connection part of the active layer 20 to be maintained inside a support frame of the glass pane 1, as will become clearer below.

According to the invention, the front glass 10 is a heat-tempered glass with dilatometric softening point (for example measured in accordance with ASTM C338-93 *Standard Test Method for Softening Point)* higher than or equal to 650°C, preferably higher than 660°C. Preferably, the softening point is also lower than 680°C.

These softening point values are decidedly higher than those of standard glass used in the building industry (for example defined in UNI EN 572) and it was surprisingly discovered that by using such a glass sheet as outer layer on the sun side it is possible to produce photovoltaic glass panes and photovoltaic structural panels with a surprising fire-resistance capacity.

Preferably, the front glass sheet 10 on the sun side has a fire resistance period of at least 30 minutes, namely it is classifiable as at least E30 according to the standard EN13501 (December 2019).

The front glass sheet 10 may be a borosilicate or alkaline earth silicate sheet. However such glass sheets are extremely costly and preferably the front glass sheet is made of soda-lime silicate glass in accordance with the standard EN 572 (December 2019).

Preferably the front sheet 10 comprises a percentage by weight of Na₂O equal to between 10% and 12%, in particular less than or equal to 11%, even more preferably less than or equal to 10.5%. Owing to this characteristic feature the heat tempering may be increased and the softening point raised.

The percentage of aluminium oxide is preferably 2% by weight, so as to provide the glass sheet 10 with a greater hydrolytic resistance.

A content of MgO greater than or equal to 3% by weight may be chosen in order to improve the chemical resistance, while reducing the viscosity of the glass.

The outer glass sheet preferably has a very low percentage content of iron, less than or equal to 1% by weight, which may contribute both towards raising the softening point and improving the transparency of the front glass 10, thereby increasing the efficiency of the photovoltaic glass pane 1.

The outer glass 10 may have very precise finishing of the edges, with micro-fissures smaller than 250 nm. For example, this may be obtained by means of super fine grain grinding (<50micro-m), in particular with a plurality of gradual grinding/polishing steps such as to avoid as far as possible the formation of micro-fractures. The material removed at each step must be preferably between 0.5 mm and a maximum of 2 mm.

In particular, the front glass sheet may have a round or flat, glossy, flush-ground perimetral edge.

As is known, the bottom cooling point, also called bottom relaxation limit" or "deformation point", represents the maximum operating temperature of a glass component. Above this limit temperature, the internal mechanical stresses are gradually reduced and the properties are modified permanently (but not irreversibly). The viscosity of the glass at the bottom softening point is by definition 10^{14,5} Pa s.

The front glass sheet has preferably a bottom cooling point higher than or equal to 535°C. This is advantageous in order to obtain optimum heat tempering. Optimum heat tempering allows a reduction in the incidence of micro-fissures along the edges of the glass sheet which may be the cause of spontaneous breakage in the case of fire stress. The possibility of greater tempering of the glass ensures a better stability in the event of fire.

In the event of a fire, the central part of the glass is more exposed and therefore hotter, while the edges are colder since they are protected by the door or window frame.

Owing to the use, in a photovoltaic glass pane, of a heat-tempered front glass sheet according to the invention, preferably with edges which are devoid of micro-fissures greater than 250 nm, it is possible to obtain a better resistance in the event of non-uniform distribution of the heat on the surface of the photovoltaic glass pane.

The front glass sheet may have a thickness, for example, less than or equal to 19 mm, in particular less or equal to 15 mm or 10 mm, more particularly less than or equal to 8 mm.

Preferably, the front glass sheet has a thickness greater than or equal to 4 mm, preferably greater than or equal to 8 mm.

The transparency of the front layer 10 is preferably greater than or equal to 90.5%. In any case preferably the front glass sheet 10 is made of glass classified as being "super clear".

It is understood that the above preferred characteristics described may be combined all or partly by the design engineer so as to choose the front glass sheet 10 suitable for the design specifications, provided that it has overall the necessary fire-resistance characteristics.

As regards the rear glass sheet 30, this is preferably a single-piece glass sheet. However, it could also be a laminated glass pane.

It is also envisaged that a plurality of rear glass sheets may be arranged between the active layer 20 and the inner side I.

The rear glass sheet may have a thickness, for example, less than or equal to 19 mm, in particular less or equal to 15 mm or 10 mm, more particularly less than or equal to 8 mm.

Preferably, the rear glass sheet has a thickness greater than or equal to 4 mm, preferably greater than or equal to 8 mm.

Depending on the design characteristics, the thickness of the rear sheet may be for example between 0.5 and 1.5, preferably between 0.8 and 1.2 times the thickness of the front sheet. In some cases, however, it could also be greater than 1.5 times the thickness of the front glass sheet.

The glass 30 behind the cells is preferably a sheet of glass, in particular float glass, which has undergone heat hardening treatment. As is known, heat hardening is a heat treatment similar to tempering, but, unlike the latter, it involves gradual cooling of the glass sheet after it has been brought to a suitable temperature generally higher than or equal to 600°C. Preferred methods and characteristics of heat hardening and of the heat-hardened glass are described in the standards UNI ENI 1863-1:2002 and UNI EN 1863-2:2005.

This heat hardening characteristic provides the photovoltaic glass pane 1 with a greater structural strength and fire-resistance, also in conditions where the rear glass is broken, preventing the propagation of mechanical shocks to the front glass on the sun side and further reducing the risk of the known "bulge/sack effect" occurring.

The Applicant has in fact surprisingly discovered that a rear glass sheet which has been heat-hardened, rather than tempered, is preferable for use in a structural photovoltaic glass pane according to the present invention; a tempered glass sheet in fact breaks into small pieces, while a hardened glass sheet breaks into larger pieces and produces a mechanical shatter effect less intense than that produced by a tempered glass sheet.

Moreover, by laminating a hardened rear glass sheet with a tempered front glass sheet, in the event of breakage (of both of them), the "bulge/sack effect" does not occur.

It is therefore preferable that the rear glass sheet should have a softening point and/or a fire-resistance period which is less than that of the front glass sheet 10 on the sun side. It is even more preferable that the front glass sheet 10 should be the layer of the laminated photovoltaic glass pane 1 with the highest softening point and/or with the greatest fire-resistance period.

In fact, the delayed softening and/or greater fire-resistance period of the front sun-side layer 10 is such as to cause the collapse firstly of all the other inner layers which are not fire-resistant. The Applicant has surprisingly noted that, during a fire, the photovoltaic layer burns and becomes slippery (because it has liquefied) both owing to the cells and because of the presence of PVB. Also the one or more inner glass sheets 30 which form the photovoltaic sandwich arrangement may break on account of the high temperature during a fire. The breakage of one or more inner glass sheets may transmit to the front layer 10 mechanical shocks, but, because it has a higher softening point, the fire-resistant glass layer 10 does not break and allows all the other layers of the photovoltaic glass pane 1 to slide on top of the front glass layer 10.

At the end of the first stage of a fire, the outer sun-side layer 10 is therefore the only one remaining and may assume a plastic behaviour so as not to allow smoke and flames to escape, without the need for any mechanical performance characteristic apart from a minimum self-supporting capacity.

Therefore, these characteristics are also able ensure a greater structural strength and fire-resistance, in particular in relation to mechanical shocks occurring during a fire.

The photovoltaic glass pane 1 is preferably a single laminated body obtained by means of lamination in an autoclave, or similar process where a plurality of layers are superimposed, heated and compressed in order to form a single laminated body.

A process according to the invention for producing the photovoltaic glass pane may comprise the following steps:
- preparing a front sheet of glass on the sun side with the aforementioned characteristics;
- preparing an active layer 20 with the aforementioned characteristics;
- preparing at least one rear glass sheet 30;
- superimposing front glass sheet 10, active layer 20 and at least one rear glass sheet 30 in a direction of thickness Z-Z;
- lamination by means of heating and compression of the superimposed layers, in particular inside an autoclave, so as to form a photovoltaic glass pane in the form of a single laminated body.

The photovoltaic glass pane is therefore preferably laminated in an autoclave. Advantageously, the lamination operation which forms the sandwich structure may consist of a cycle which modulates pressure and temperature in a controlled manner, without any particular measures compared to those already used for the production of photovoltaic sandwich structures.

Following this operation the connection means and the on-board electronics may be applied to the active layer 20, using techniques which are conventional per se.

The fire-resistant photovoltaic glass pane according to the present invention may be used to form a structural photovoltaic panel (i.e. a glass structural element for building use, with photovoltaic layer), for example for use in external architectural elements of a building.

With reference to Figure 3, an example of a fire-resistant photovoltaic panel according to the present invention is in the form of a double-glazed unit 100 comprising an outer glass pane 101 formed by a photovoltaic laminated glass pane according to the present invention which during use is arranged facing the outside and exposed to the sun, and an inner glass pane 150. The outer glass pane 101 on the sun side and the inner glass pane 150 are joined together along the perimeter with the arrangement, between them, of a spacing frame-piece or channel 141, for example made of profiled metal or plastic, so as to form a cavity 143, or insulating chamber, designed to contain dehydrated air or gas (usually argon or krypton). The spacing channel 141 is in particular structured so as to be able to house salts 141a designed to keep the air inside the insulating chamber 143 dehydrated. As shown, a layer of sealing material 142 may be arranged perimetrally around the channel 141. The sealing material 142 is preferably a glass/glass structural silicone (e.g. Dow Corning 3363), in particular with at least 6 mm depth. The weight and volume of the sealing material 142 preferably is not more than 0.1% of the photovoltaic panel.

The channel 141 is preferably made of stainless steel, for example Cromatech Plus Inox (Rolltech). In the event of a fire, this embodiment helps keep the panel in place, preventing it from collapsing inwards, since it has a greater heat resistance, this being preferable to a "controlled" breakage which is normally used for this type of double-glazed unit.

The inner glass pane 150 is preferably a (pre-)laminated glass pane in which one or more layers of transparent thermoplastic resin are arranged between two or more glass sheets, in particular a laminated safety glass pane in accordance with the standard UNI EN ISO12543 and/or CEI EN 61730, which is able to retain the fragments in the event of breakage.

The inner glass pane 150 may be for example a 66.2 pre-laminated glass pane, but it will be clear to the person skilled in the art that other structural and/or pre-laminated glass panes may be used in the panel 100 according to the invention.

In Figure 3, the photovoltaic structural panel 100 according to the present invention is shown retained by glass-fastener means 160 in the form of pressers 161 connected by tie-bolts 162. Preferably, a respective heat-expanding - in particular graphite-based - seal 163 is arranged between the pressers 161 and the panel.

As shown, the pressers 161 act on the inner surface and on the sun-side outer surface of the panel 100, overlapping them by a certain overlapping distance d1 measured from the outer perimetral edge of the respective inner or outer glass pane of the structural panel.

This overlapping distance d1 is preferably, at least on the front side "S" smaller than or equal to 12 mm.

Preferably also, the distance between the side of the channel 141 on the inside of the chamber 143 and the perimetral edge of the panel is less than or equal to 12 mm and/or substantially equal to this distance d1.

This feature advantageously ensures that the heat produced by combustion is distributed more uniformly without giving rise to "cold" zones which may trigger the breakage of the front layer 10.

The panel according to the present invention may include further insulating chambers and further glass panes, provided that the fire-resistant laminated glass pane according to the present invention is the outermost one overall.

A fire-resistant photovoltaic panel 100 according to the present invention may be joined to a frame designed to be fixed to a wall, in particular an outer wall of a building, so as to form an architectural element and in particular continuous façade element, a roofing or a window.

The frame may be of any known type for use as a window or door frame in continuous façade elements, for example a fire-breaker window or door frame used for passive continuous facades with steel uprights and cross-pieces, comprising supports for the panel and presser-type glass fasteners joined to the uprights and cross-pieces. The connection means and on-board electronics of the photovoltaic panel may be housed inside the frame, so as not to affect the impermeability thereof.

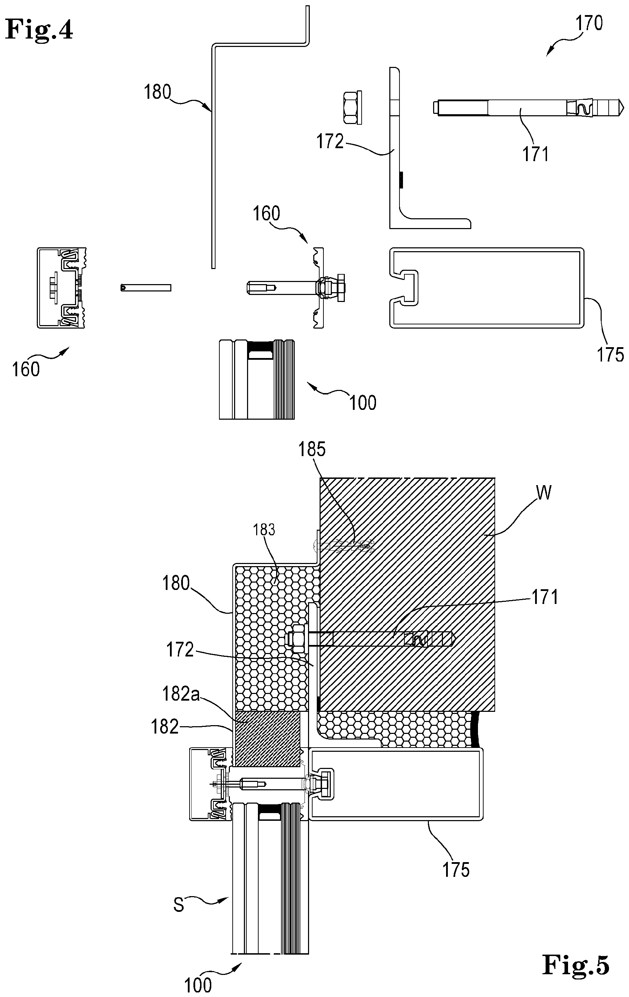

With reference to Figs. 4-5 an example of embodiment of a continuous façade element, such as a structural double-glazed unit, which includes a photovoltaic panel 100 according to the present invention mounted on a frame designed to be fixed to a wall W, in particular an outer wall of a building, is now described.

In the example shown, the frame comprises a structure 175, with uprights and cross-pieces, designed to be rigidly joined to the wall. The glass-fastener means 160 are designed to be joined to the frame and to retain or support the photovoltaic panel 100 according to the invention on the uprights and cross-pieces, in particular by means of presser elements 161. Swelling seals 163, in particular graphite-based, for example of the type comprising a double row of heat-expanding graphite-based tape, are preferably arranged between the pressers 161 and the panel.

Means 170 for fixing the frame to the wall comprise, for example, a plurality of angle brackets 172, one side of which is designed to be fixed by means of anchoring plugs 171 to the wall and the other side of which is designed to be rigidly connected to the structure 175 of the frame.

A cover comprising one or more closing cases 180 is designed to be retained by the glass-fastener means 160 on the outer side of the window or door frame and fixed to the wall W by suitable fixing means 185.

Advantageously, the cases may be made of stainless steel and filled with an insulating filler material 183, in particular rock wool.

The part of the case 182 subject to the action of the clamping pressers 160 is preferably filled with calcium silicate 182a.

Air-tight seals optionally provided with a water-tight sealing lip, preferably of the non-combustible type, may be arranged between the frame and the panel 100.

### EXAMPLE 1

The continuous façade element of Example 1 is composed of the following:
- a panel according to the invention in the form of a double-glazed unit formed by:
   -- a 16 mm spacing channel, Cromatech Plus Inox (Rolltech) + Argon, sealed with Dow Corning 3363 silicone, which joins along the perimeter:
   -- a photovoltaic laminated glass pane according to the present invention, formed in an autoclave, with:
      - front glass pane on sun side, Piroswiss Diamant (Vetrotech Saint-Gobain), with 8 mm thickness;
      - rear float glass pane treated by means of heat hardening.

Inside the aforementioned front and rear glass panes there are 2 PVB solar sheets, 0.76 mm each, which enclose crystalline silicon photovoltaic cells;
- the interconnection means are copper electrical interconnection ribbons;
- on-board electronics composed of SPV 1540 N diodes contained in ABS containers and embedded in heat-conducting, dielectric, adhesive silicone, type DOWSIL SE 4422;
- connection cables, type H1Z2Z2-K 4 mm², 1.2 m long each, directly welded together with the output ribbons from the glass pane, the welds of which are insulated with type Dow Corning PV-804 silicone and protected by ABS covers;
- terminals for electrical interconnection between modules of the type MC4; and
   -- a 66.2 pre-laminated (inner) rear glass pane;
- a frame consisting of a window or door frame, model VISS FIRE TV made by JANSEN with uprights and cross-pieces;
- presser-type glass-fastener supports, joined to inserts of the frame, made with calcium silicate (Promatec REI);
- fillers subject to the action of the pressers, consisting of calcium silicate (Promatec REI);
- air-tight non-combustible seals for the frame;
- a graphite-based heat-expanding seal is placed beforehand between the pressers and the panel;
- cases and bolts made of stainless steel;
- the filling of the cases consists of rock wool.

The panel had an overall thickness of 46 m, a height of 240 cm and a length of 1250 mm.

### Behaviour of the panel

The fire resistance of the panel in Example 1 was tested in accordance with the standard UNI EN 1363-1: 2012 (para. 11.1).

The frame with panel was fixed to an opening in a wall of a closed furnace by means of eight angle brackets welded to the frame and secured to the wall by means of steel anchoring plugs; a combustion apparatus was ignited inside the closed furnace so as to generate a flame only on the inner side of the panel, and the panel mounted on the frame was exposed to rising temperatures in accordance with the heating curve of the cited standard UNI EN 1363-1, up to a temperature of 900°C. After 46 minutes the furnace was switched off because of external problems due to the irradiation in the surrounding environment.

The results of test are described in Table 1.

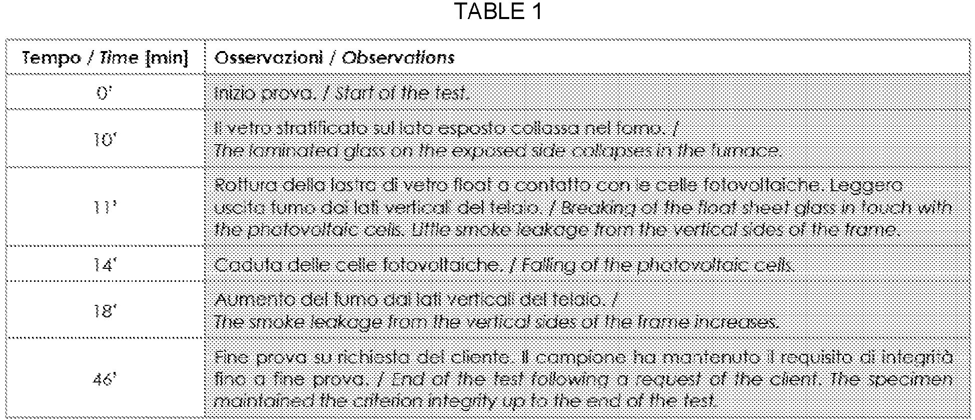

The results of the integrity tests carried out on samples of the panel following the initial test are shown in Table 2.

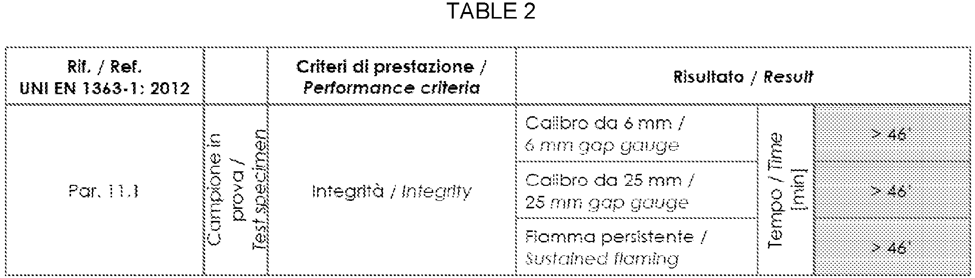

As can be seen, the panel retained its structural integrity and its sealed condition for 46 minutes and maintained these characteristics also during the subsequent cooling step.

The panel in Example 1 was also found to have, following the laboratory test, the following characteristics:
**Luminous characteristics - EN 410**

| | |
|---|---|
| Light transmission: | TV [%] 18 |
| Light reflection: | ρv [%] 10 |
| Internal light reflection: | ρvi [%] 15 |
| Colour yield index: | Ra [%] 98 |

**Energy characteristics** - **EN 410**

| | |
|---|---|
| Solar factor: | g [%] 25 |
| External energy reflection: | ρe [%] 10 |
| Internal energy reflection: | ρei [%] 12 |
| Direct transmission of the energy: | τe [%] 16 |
| Energy absorption, glass pane 1: | αe1 [%] 71 |
| Energy absorption, glass pane 2: | αe2 [%] 3 |
| Total energy absorption: | αe [%] 74 |
| Shading coefficient: | SC 0.28 |
| Transmission of ultraviolet rays: | τuv [%] 0 |
| Selectivity | 0.74 |

**Thermal properties - EN 673**

| | |
|---|---|
| (Vertical) heat transmittance: | Ug [W/(m².K)] 2.4 |

**Safety characteristics**

| | |
|---|---|
| Smash resistance - EN 356 | P4A |
| Impact resistance (pendulum test) - EN 12600: | 1B1 / 1B1 |

**Thickness and weight**

| | |
|---|---|
| Nominal thickness: [mm] | 46.3 |
| Weight: [kg/m²] | 72 |

It is therefore clear how the photovoltaic glass pane according to the present invention is fire-resistant without the need for surface coatings which would limit its ease of handling and adversely affect the economic viability of the design.

The laminated glass pane and the photovoltaic panel according to the present invention can be classified as at least E30 and as belonging to the A1 fire reaction class, in accordance with the Decision 2000/147/EC, being therefore suitable as building products to be used in works for which the requisite of safety in the event of fire is prescribed.

The photovoltaic glass pane according to the present invention is such as to render the autoclave lamination cycles sustainable without the front glass on the sun side reacting to heat or needing special modifications to this type of process.

With the photovoltaic glass pane according to the present invention it is possible to provide photovoltaic structural panels with improved fire resistance, while maintaining the characteristic of structural safety glass.

In preferred embodiments, it is possible to use a front glass pane with the transparency of "low iron" glass also known as "extra-clear" glass, which is particularly advantageous as sun-side glass for a photovoltaic panel. Thus, the improved fire resistance is accompanied by an optimal electrical yield of the panel.

Since the sun-side front glass is tempered glass, it is possible to form the photovoltaic glass panes or panels according to the invention while maintaining the mechanical strength of tempered glass, without the need for substantial changes to the structural calculation models currently used by design engineers in the sector.

With the photovoltaic glass pane according to the present invention it is possible to avoid the propagation of mechanical shocks to the outer sun-side glass during combustion. Preferably, the rear glass is a sheet of glass which has undergone heat hardening treatment which, as a whole, provides the photovoltaic glass pane with additional structural strength even under breakage conditions and makes it possible to avoid the well-known "bulge/sack effect".

With the photovoltaic panel according to the invention the heat generated by the combustion may be uniformly distributed without creating "cold" zones that could trigger the breakage of the outer sun-side glass E30/E45.

The panel according to the invention does not need altimetric valves to dispose of the overpressure inside the insulating chamber during heating by combustion inside the room.

Although described in connection with a number of embodiments and a number of preferred examples of implementation of the invention, it is understood that the scope of protection of the present patent is determined solely by the claims below.

## Claims

1. Photovoltaic laminated glass pane (1) extending in a direction of thickness (Z-Z) between a front side or sun side (S) and a rear side (I) and comprising a plurality of superimposed layers in said direction of thickness, said layers comprising a front glass sheet (10), the front surface of which forms the sun side (S), a rear glass sheet (30) and at least one photovoltaic layer (20) arranged between the front glass sheet (10) and the rear glass sheet (30), wherein the photovoltaic layer (20) has an active layer designed to be irradiated by solar energy and to produce electric energy and wherein the front glass sheet (10) is made of a heat-tempered glass with a dilatometric softening point higher than or equal to 650°C, preferably higher than 660°C;
**characterized in that** the rear glass sheet (30) is a sheet of glass which has undergone heat hardening treatment and/or has a softening point and/or fire resistance period less than that of the front glass sheet (10) on the sun side.

2. Photovoltaic laminated glass pane according to Claim 1, wherein the front glass sheet (10) on the sun side has a fire resistance period of at least 30 minutes, in compliance with the standard UNI EN 1363-1 (2012).

3. Photovoltaic laminated glass pane according to Claim 1 or 2, wherein the front glass sheet (10) is made of heat-tempered glass with a dilatometric softening point lower than 680°C.

4. Photovoltaic laminated glass pane according to one of the preceding claims, wherein the front glass sheet (10) comprises a percentage by weight of Na₂O ranging between 10% and 12%, in particular less than or equal to 11%, even more preferably less than or equal to 10.5%.

5. Photovoltaic laminated glass pane according to one of the preceding claims, wherein the front glass sheet (10) comprises a percentage of aluminium oxide preferably greater than 2% by weight, and/or a content of MgO greater than or equal to 3% by weight, and/or a percentage content of iron less than or equal to 1% by weight.

6. Photovoltaic laminated glass pane according to one of the preceding claims, **characterized in that** the front glass sheet has a perimetral edge with a finish such as not to have micro-fissures greater than 250 nm and/or **in that** the front glass sheet has a round or flat, glossy, flush-ground perimetral edge.

7. Photovoltaic laminated glass pane according to one of the preceding claims, **characterized in that** the front glass sheet has a thickness less than or equal to 19 mm, in particular less than or equal to 15 mm or 10 mm, more particularly less than or equal to 8 mm; and/or **in that** the front glass sheet on the sun side has a thickness greater than or equal to 4 mm, preferably greater than or equal to 8 mm.

8. Photovoltaic laminated glass pane according to one of the preceding claims, **characterized in that** the front glass sheet has a transparency greater than or equal to 90.5% and/or **in that** the front glass sheet (10) consists of glass classified as super clear.

9. Photovoltaic laminated glass pane according to one of the preceding claims, **characterized in that** the rear glass sheet (30) is a sheet of float glass or laminated glass.

10. Photovoltaic laminated glass pane according to one of the preceding claims, **characterized in that** the thickness of the rear glass sheet is less than or equal to 19 mm, in particular less than or equal to 15 mm or 10 mm, more particularly less than or equal to 8 mm; and/or **in that** the rear glass sheet has a thickness greater than or equal to 4 mm, preferably greater than or equal to 8 mm.

11. Photovoltaic laminated glass pane according to one of the preceding claims, **characterized in that** the thickness of the rear sheet is between 0.5 and 1.5, preferably between 0.8 and 1.2 times the thickness of the front sheet.

12. Photovoltaic laminated glass pane according to one of the preceding claims, **characterized in that** the front glass sheet (10) is the layer of photovoltaic laminated glass pane (1) with the highest softening point value and/or with the longest fire resistance period.

13. Photovoltaic laminated glass pane according to one of the preceding claims, wherein the front glass sheet (10) on the sun side is made of glass with a bottom cooling point higher than or equal to 535°C.

14. Photovoltaic laminated glass pane according to one of the preceding claims, **characterized in that** it is in the form of a single-piece body which is laminated layerwise, in particular inside an autoclave.

15. Process for producing a photovoltaic laminated glass pane according to one of the preceding claims, comprising the steps of:
- preparing a front sheet of heat-tempered glass on the sun side with a dilatometric softening point higher than or equal to 650°C, preferably higher than 660°C and preferably lower than 680°C;
- preparing a photovoltaic layer (20) which has an active layer designed to be irradiated by solar energy and to produce electric energy;
- preparing at least one rear glass sheet (30) which is a sheet of glass which has undergone heat hardening treatment and/or has a softening point and/or fire resistance period less than that of the front glass sheet (10) on the sun side;
- superimposing front glass sheet (10), photovoltaic layer (20) and at least one rear glass sheet (30) in a direction of thickness (Z-Z);
- lamination by means of heating and compression of the superimposed layers, in particular inside an autoclave, so as to form a photovoltaic glass pane in the form of a single laminated body.

16. Fire-resistant photovoltaic panel for use in external architectural elements, comprising a photovoltaic laminated glass pane according to one of Claims 1-14, arranged in an outer position so that the front glass sheet is the outermost glass sheet of the photovoltaic panel, which during use is exposed to the sun.

17. Fire-resistant photovoltaic panel according to the preceding claim, **characterized in that** it is in the form of a double-glazed unit comprising the outer photovoltaic laminated glass pane and at least one inner glass pane, which are joined together at the perimeter, and at least one spacing channel which forms a respective insulating chamber between the outer laminated glass pane and the inner glass pane, wherein optionally the double-glazed unit comprises multiple frames and intermediate glass panes for forming respective multiple insulating chambers.

18. Fire-resistant photovoltaic panel according to the preceding claim, wherein the spacing channel is made of metal, in particular stainless steel, and/or the rear glass consists of laminated glass, preferably laminated safety glass.

19. External architectural element for a building, in particular a continuous façade element, a roofing or a window, comprising a fire-resistant photovoltaic panel (100) according to one of Claims 16-18 and a frame designed to be fixed to an external wall of the building,

20. Architectural element according to the preceding claim, wherein the frame is a window or door fire-breaker frame used for passive continuous façades comprising uprights and cross-pieces and/or comprises panel supports and presser-type glass fasteners.

21. Architectural element according to one of Claims 19-20, wherein on-board electronics and connection means of the photovoltaic glass panel are housed inside the frame and/or wherein swelling seals (163), in particular of the graphite-based type, for example of the type comprising a double row of heat-expanding graphite-based tape, are arranged between the glass-fastening means and the photovoltaic panel.

22. Architectural element according to one of Claims 19-21, further comprising a cover comprising one or more closing cases (180), preferably made of stainless steel, filled with an insulating filler material (183), in particular rock wool.

23. Photovoltaic panel according to one of Claims 16-18 or architectural element according to one of Claims 19-22, **characterized in that** it has a fire resistance period of at least 30 minutes, in compliance with the standard UNI EN 1363-1 (2012).

## Patentansprüche

1. Photovoltaische Verbundglasscheibe (1), die sich in einer Dickenrichtung (Z-Z) zwischen einer Vorderseite oder Sonnenseite (S) und einer Rückseite (I) erstreckt und eine Vielzahl von übereinanderliegenden Schichten in der Dickenrichtung umfasst, wobei die Schichten eine vordere Glasscheibe (10), deren vordere Oberfläche die Sonnenseite (S) bildet, eine hintere Glasscheibe (30) und mindestens eine photovoltaische Schicht (20) umfassen, die zwischen der vorderen Glasscheibe (10) und der hinteren Glasscheibe (30) angeordnet ist, wobei die photovoltaische Schicht (20) eine aktive Schicht aufweist, die so ausgelegt ist, dass sie von Sonnenenergie bestrahlt wird und elektrische Energie erzeugt, und wobei die vordere Glasscheibe (10) aus einem wärmegehärteten Glas mit einem dilatometrischen Erweichungspunkt von mehr als oder gleich 650 °C, vorzugsweise mehr als 660 °C, besteht, **dadurch gekennzeichnet, dass** die hintere Glasscheibe (30) eine Glasscheibe ist, die einer Wärmebehandlung unterzogen wurde und/oder einen Erweichungspunkt und/oder eine Feuerwiderstandsdauer aufweist, der/die geringer ist als der/die der vorderen Glasscheibe (10) auf der Sonnenseite.

2. Photovoltaische Verbundglasscheibe gemäß Anspruch 1, wobei die vordere Glasscheibe (10) auf der Sonnenseite eine Feuerwiderstandsdauer von mindestens 30 Minuten gemäß der Norm UNI EN 1363-1 (2012) aufweist.

3. Photovoltaische Verbundglasscheibe gemäß Anspruch 1 oder 2, wobei die vordere Glasscheibe (10) aus thermisch gehärtetem Glas mit einem dilatometrischen Erweichungspunkt von weniger als 680 °C besteht.

4. Photovoltaische Verbundglasscheibe gemäß einem der vorstehenden Ansprüche, wobei die vordere Glasscheibe (10) einen Gewichtsanteil an Na₂O zwischen 10 % und 12 %, insbesondere weniger als oder gleich 11 %, noch stärker bevorzugt weniger als oder gleich 10,5 %, umfasst.

5. Photovoltaische Verbundglasscheibe nach einem der vorstehenden Ansprüche, wobei die vordere Glasscheibe (10) einen Aluminiumoxidgehalt von vorzugsweise mehr als 2 Gew.-% und/oder einen MgO-Gehalt von mehr als oder gleich 3 Gew.-% und/oder einen Eisengehalt von weniger als oder gleich 1 Gew.-% aufweist.

6. Photovoltaische Verbundglasscheibe gemäß einem der vorstehenden Ansprüche, **dadurch gekennzeichnet, dass** die vordere Glasscheibe eine Umfangskante mit einer Oberflächenbeschaffenheit aufweist, die keine Mikrorisse größer als 250 nm aufweist, und/oder dass die vordere Glasscheibe eine runde oder flache, glänzende, bündig geschliffene Umfangskante aufweist.

7. Photovoltaische Verbundglasscheibe gemäß einem der vorhergehenden Ansprüche, **dadurch gekennzeichnet, dass** die vordere Glasscheibe eine Dicke von höchstens 19 mm, insbesondere höchstens 15 mm oder 10 mm, genauer gesagt höchstens 8 mm, aufweist; und/oder dass die vordere Glasscheibe auf der Sonnenseite eine Dicke von mindestens 4 mm, vorzugsweise mindestens 8 mm, aufweist.

8. Photovoltaische Verbundglasscheibe nach einem der vorhergehenden Ansprüche, **dadurch gekennzeichnet, dass** die vordere Glasscheibe eine Lichtdurchlässigkeit von mindestens 90,5 % aufweist und/oder dass die vordere Glasscheibe (10) aus als superklar klassifiziertem Glas besteht.

9. Photovoltaische Verbundglasscheibe gemäß einem der vorstehenden Ansprüche, **dadurch gekennzeichnet, dass** die hintere Glasscheibe (30) eine Scheibe aus Floatglas oder Verbundglas ist.

10. Photovoltaische Verbundglasscheibe nach einem der vorhergehenden Ansprüche, **dadurch gekennzeichnet, dass** die Dicke der hinteren Glasscheibe kleiner oder gleich 19 mm, insbesondere kleiner oder gleich 15 mm oder 10 mm, genauer kleiner oder gleich 8 mm ist; und/oder dass die hintere Glasscheibe eine Dicke größer oder gleich 4 mm, vorzugsweise größer oder gleich 8 mm, aufweist.

11. Photovoltaische Verbundglasscheibe gemäß einem der vorhergehenden Ansprüche, **dadurch gekennzeichnet, dass** die Dicke der hinteren Scheibe zwischen dem 0,5- und 1,5-Fachen, vorzugsweise zwischen dem 0,8- und 1,2-Fachen der Dicke der vorderen Scheibe beträgt.

12. Photovoltaische Verbundglasscheibe nach einem der vorhergehenden Ansprüche, **dadurch gekennzeichnet, dass** die vordere Glasscheibe (10) die Schicht der photovoltaischen Verbundglasscheibe (1) mit dem höchsten Erweichungspunktwert und/oder mit der längsten Feuerwiderstandsdauer ist.

13. Photovoltaische Verbundglasscheibe nach einem der vorhergehenden Ansprüche, wobei die vordere Glasscheibe (10) auf der Sonnenseite aus Glas mit einem unteren Kühlpunkt von größer oder gleich 535 °C besteht.

14. Photovoltaische Verbundglasscheibe nach einem der vorhergehenden Ansprüche, **dadurch gekennzeichnet, dass** sie in Form eines einteiligen Körpers vorliegt, der schichtweise laminiert ist, insbesondere innerhalb eines Autoklaven.

15. Verfahren zur Herstellung einer photovoltaischen Verbundglasscheibe gemäß einem der vorstehenden Ansprüche, umfassend die folgenden Schritte:
- Herstellung einer vorderen Scheibe aus wärmegehärtetem Glas auf der Sonnenseite mit einem dilatometrischen Erweichungspunkt von mindestens 650 °C, vorzugsweise über 660 °C und vorzugsweise unter 680 °C;
- Herstellung einer photovoltaischen Schicht (20), die eine aktive Schicht aufweist, die dazu bestimmt ist, von Sonnenenergie bestrahlt zu werden und elektrische Energie zu erzeugen;
- Herstellung mindestens einer hinteren Glasscheibe (30), die eine Glasscheibe ist, die einer Wärmebehandlung unterzogen wurde und/oder einen Erweichungspunkt und/oder eine Feuerwiderstandsdauer aufweist, der/die geringer ist als der/die der vorderen Glasscheibe (10) auf der Sonnenseite;
- Übereinanderlegen der vorderen Glasscheibe (10), Photovoltaikschicht (20) und mindestens einer hinteren Glasscheibe (30) in einer Dickenrichtung (Z-Z);
- Laminieren durch Erhitzen und Komprimieren der übereinanderliegenden Schichten, insbesondere in einem Autoklaven, um eine Photovoltaikglasscheibe in Form eines einzelnen laminierten Körpers zu bilden.

16. Feuerbeständige Photovoltaikscheibe zur Verwendung in architektonischen Außenelementen, die eine photovoltaische Verbundglasscheibe gemäß einem der Ansprüche 1 bis 14 umfasst, die an einer äußeren Position angeordnet ist, sodass die vordere Glasscheibe die äußerste Glasscheibe der Photovoltaikscheibe ist, die während der Verwendung der Sonne ausgesetzt ist.

17. Feuerbeständige Photovoltaikscheibe gemäß dem vorhergehenden Anspruch, **dadurch gekennzeichnet, dass** es in Form einer Doppelglaseinheit vorliegt, die die äußere photovoltaische Verbundglasscheibe und mindestens eine innere Glasscheibe umfasst, die am Umfang miteinander verbunden sind, und mindestens einen Abstandskanal, der eine jeweilige Isolierkammer zwischen der äußeren Verbundglasscheibe und der inneren Glasscheibe bildet, wobei die Doppelverglasungseinheit optional mehrere Rahmen und Zwischenglasscheiben zur Bildung mehrerer Isolierkammern umfasst.

18. Feuerbeständige Photovoltaikscheibe nach dem vorhergehenden Anspruch, wobei der Abstandskanal aus Metall, insbesondere Edelstahl, besteht und/oder die hintere Glasscheibe aus Verbundglas, vorzugsweise Verbundsicherheitsglas, besteht.

19. Äußeres Architekturelement für ein Gebäude, insbesondere ein durchgehendes Fassadenelement, eine Überdachung oder ein Fenster, umfassend eine feuerbeständige Photovoltaikscheibe (100) gemäß einem der Ansprüche 16 bis 18 und einen Rahmen, der zur Befestigung an einer Außenwand des Gebäudes ausgelegt ist.

20. Architekturelement gemäß dem vorhergehenden Anspruch, wobei der Rahmen ein Fenster- oder Türrahmen mit Brandschutzfunktion ist, der für passive durchgehende Fassaden verwendet wird, die Pfosten und Querstreben umfassen, und/oder Scheibenhalterungen und Druckglasbefestigungen umfasst.

21. Architekturelement gemäß einem der Ansprüche 19 bis 20, wobei die Bordelektronik und die Verbindungsvorrichtung der Photovoltaische Glasscheibe im Rahmen untergebracht sind und/oder wobei Quelldichtungen (163), insbesondere vom graphitbasierten Typ, beispielsweise vom Typ, der eine doppelte Reihe von wärmeexpandierendem Band auf Graphitbasis umfasst, zwischen der Glasbefestigungsvorrichtung und der Photovoltaikscheibe angeordnet sind.

22. Architekturelement gemäß einem der Ansprüche 19 bis 21, das außerdem eine Abdeckung mit einem oder mehreren Verschlussgehäusen (180) umfasst, die vorzugsweise aus Edelstahl bestehen und mit einem isolierenden Füllmaterial (183), insbesondere Steinwolle, gefüllt sind.

23. Photovoltaikscheibe gemäß einem der Ansprüche 16 bis 18 oder Architekturelement gemäß einem der Ansprüche 19 bis 22, **dadurch gekennzeichnet, dass** es eine Feuerwiderstandsdauer von mindestens 30 Minuten gemäß der Norm UNI EN 1363-1 (2012) aufweist.

## Revendications

1. Vitre en verre feuilletée photovoltaïque (1) s'étendant dans une direction d'épaisseur (Z-Z) entre une face avant ou face soleil (S) et une face arrière (I) et comprenant une pluralité de couches superposées dans ladite direction d'épaisseur, lesdites couches comprenant une feuille de verre avant (10) dont la surface avant forme la face soleil (S), une feuille de verre arrière (30) et au moins une couche photovoltaïque (20) disposée entre la feuille de verre avant (10) et la feuille de verre arrière (30), dans laquelle la couche photovoltaïque (20) présente une couche active destinée à être irradiée par l'énergie solaire et à produire de l'énergie électrique et dans laquelle la feuille de verre avant (10) est réalisée en un verre trempé à chaud ayant un point de ramollissement dilatométrique supérieur ou égal à 650°C, de préférence supérieur à 660°C, **caractérisée en ce que** la feuille de verre arrière a subi un traitement de durcissement thermique et/ou présente un point de ramollissement et/ou une période de résistance au feu inférieur(s) à celui ou ceux de la feuille de verre avant (10) du côté soleil.

2. Vitre en verre feuilletée photovoltaïque selon la revendication 1, dans laquelle la feuille de verre avant (10) du côté soleil présente une période de résistance au feu d'au moins 30 minutes, conformément à la norme UNI EN 1363-1 (2012).

3. Vitre en verre feuilletée photovoltaïque selon la revendication 1 ou 2, dans laquelle la feuille de verre avant (10) est réalisée en verre trempé à chaud avec un point de ramollissement dilatométrique inférieur à 680°C.

4. Vitre en verre feuilletée photovoltaïque selon l'une des revendications précédentes, dans laquelle la feuille de verre avant (10) comprend un pourcentage massique en Na₂O compris entre 10% et 12%, en particulier inférieur ou égal à 11%, encore plus préférentiellement inférieur ou égal à 10,5%.

5. Vitre en verre feuilletée photovoltaïque selon l'une des revendications précédentes, dans laquelle la feuille de verre avant (10) comprend un pourcentage d'oxyde d'aluminium de préférence supérieur à 2% en poids, et/ou une teneur en MgO supérieure ou égale à 3% en poids, et/ou une teneur en pourcentage en fer inférieure ou égale à 1% en poids.

6. Vitre en verre feuilletée photovoltaïque selon l'une des revendications précédentes, **caractérisée en ce que** la feuille de verre avant présente un bord périphérique avec une finition telle qu'elle ne présente pas de microfissures supérieures à 250 nm et/ou **en ce que** la feuille de verre avant présente un bord périphérique rond ou plat, brillant, affleurant.

7. Vitre en verre feuilletée photovoltaïque selon l'une des revendications précédentes, **caractérisée en ce que** la feuille de verre avant présente une épaisseur inférieure ou égale à 19 mm, en particulier inférieure ou égale à 15 mm ou 10 mm, plus particulièrement inférieure ou égale à 8 mm ; et/ou **en ce que** la feuille de verre avant du côté soleil présente une épaisseur supérieure ou égale à 4 mm, de préférence supérieure ou égale à 8 mm.

8. Vitre en verre feuilletée photovoltaïque selon l'une des revendications précédentes, **caractérisée en ce que** la feuille de verre avant présente une transparence supérieure ou égale à 90,5% et/ou **en ce que** la feuille de verre avant (10) est constituée de verre classé super clair.

9. Vitre en verre feuilletée photovoltaïque selon l'une des revendications précédentes, **caractérisée en ce que** la feuille de verre arrière (30) est une feuille de verre flotté ou de verre feuilleté.

10. Vitre en verre feuilletée photovoltaïque selon l'une des revendications précédentes, **caractérisée en ce que** l'épaisseur de la feuille de verre arrière est inférieure ou égale à 19 mm, en particulier inférieure ou égale à 15 mm ou 10 mm, plus particulièrement inférieure ou égale à 8 mm ; et/ou **en ce que** la feuille de verre arrière a une épaisseur supérieure ou égale à 4 mm, de préférence supérieure ou égale à 8 mm.

11. Vitre en verre feuilletée photovoltaïque selon l'une des revendications précédentes, **caractérisée en ce que** l'épaisseur de la feuille arrière est comprise entre 0,5 et 1,5, de préférence entre 0,8 et 1,2 fois l'épaisseur de la feuille avant.

12. Vitre en verre feuilletée photovoltaïque selon l'une des revendications précédentes, **caractérisée en ce que** la feuille de verre avant (10) est la couche de la vitre en verre feuilletée photovoltaïque (1) avec la valeur de point de ramollissement la plus élevée et/ou la période de résistance au feu la plus longue.

13. Vitre en verre feuilletée photovoltaïque selon l'une des revendications précédentes, dans laquelle la feuille de verre avant (10) du côté soleil est réalisée en un verre avec un point de refroidissement inférieur supérieur ou égal à 535°C.

14. Vitre en verre feuilletée photovoltaïque selon l'une des revendications précédentes, **caractérisée en ce qu'**elle est sous la forme d'un corps monobloc qui est feuilleté couche par couche, en particulier à l'intérieur d'un autoclave.

15. Procédé de fabrication d'une vitre en verre feuilletée photovoltaïque selon l'une des revendications précédentes, comprenant les étapes de :
- préparer une feuille avant en verre trempé à chaud du côté soleil avec un point de ramollissement dilatométrique supérieur ou égal à 650°C, de préférence supérieur à 660°C et de préférence inférieur à 680°C ;
- préparer une couche photovoltaïque (20) qui comporte une couche active destinée à être irradiée par l'énergie solaire et à produire de l'énergie électrique ;
- préparer au moins une feuille de verre arrière (30) qui est une feuille de verre qui a subi un traitement de durcissement thermique et/ou présente un point de ramollissement et/ou une période de résistance au feu inférieur(s) à celui ou ceux de la feuille de verre avant (10) du côté soleil ;
- superposer une feuille de verre avant (10), une couche photovoltaïque (20) et au moins une feuille de verre arrière (30) dans une direction d'épaisseur (Z-Z) ;
- laminage par chauffage et compression des couches superposées, en particulier à l'intérieur d'un autoclave, de manière à former une vitre en verre photovoltaïque sous la forme d'un corps feuilleté unique.

16. Panneau photovoltaïque résistant au feu destiné à être utilisé dans des éléments architecturaux extérieurs, comprenant une vitre en verre feuilletée photovoltaïque selon l'une des revendications 1 à 14, disposée dans une position extérieure de telle sorte que la feuille de verre avant est la feuille de verre la plus extérieure du panneau photovoltaïque, qui pendant l'utilisation est exposée au soleil.

17. Panneau photovoltaïque résistant au feu selon la revendication précédente, **caractérisé en ce qu'**il se présente sous la forme d'une unité à double vitrage comprenant la vitre feuilletée photovoltaïque extérieure et au moins une vitre en verre intérieure, qui sont jointes entre elles au niveau du périmètre, et au moins un canal d'espacement qui forme une chambre isolante respective entre la vitre en verre feuilletée extérieure et la vitre en verre intérieure, dans lequel de manière optionnelle, l'unité à double vitrage comprend plusieurs cadres et vitres en verre intermédiaires pour former plusieurs chambres isolantes respectives.

18. Panneau photovoltaïque résistant au feu selon la revendication précédente, dans lequel le canal d'espacement est en métal, en particulier en acier inoxydable, et/ou le verre arrière est constitué de verre feuilleté, de préférence de verre de sécurité feuilleté.

19. Elément architectural extérieur pour bâtiment, en particulier un élément de façade continue, une toiture ou une fenêtre, comprenant un panneau photovoltaïque (100) résistant au feu selon l'une des revendications 16 à 18 et un cadre destiné à être fixé à un mur extérieur du bâtiment.

20. Elément architectural selon la revendication précédente, dans lequel le cadre est un cadre coupe-feu de fenêtre ou de porte utilisé pour des façades continues passives comprenant des montants et des traverses et/ou comprend des supports de panneaux et des attaches de verre de type presseur.

21. Elément architectural selon l'une des revendications 19 à 20, dans lequel l'électronique embarqué et les moyens de connexion du panneau photovoltaïque en verre sont logés à l'intérieur du cadre et/ou dans lequel des joints gonflants (163), en particulier de type à base de graphite, par exemple de type comprenant une double rangée de ruban à base de graphite thermodilatable, sont disposés entre les moyens de fixation du verre et le panneau photovoltaïque.

22. Elément architectural selon l'une des revendications 19 à 21, comprenant en outre un couvercle comprenant un ou plusieurs boîtiers de fermeture (180), de préférence en acier inoxydable, remplis d'un matériau de remplissage isolant (183), en particulier de la laine de roche.

23. Panneau photovoltaïque selon l'une des revendications 16 à 18 ou élément architectural selon l'une des revendications 19 à 22, **caractérisé en ce qu'**il présente une période de résistance au feu d'au moins 30 minutes, conformément à la norme UNI EN 1363-1 (2012).
